# EUROPEAN PATENT APPLICATION

(11) **EP 4 401 518 A1**
(43) Date of publication of application: **17.07.2024**
(21) Application number: 22916380.3
(22) Date of filing: 04.11.2022
(51) Int. Cl.: H05K 7/14, H05K 5/00, G09F 9/302

(54) **DISPLAY APPARATUS**

(30) Priority: 29.12.2021 KR 20210190565
(71) Applicant: Samsung Electronics Co., Ltd., Suwon-si, Gyeonggi-do 16677 (KR)
(72) Inventor: KIM, Seungjae, Suwon-si Gyeonggi-do 16677 (KR); OH, Pilyong, Suwon-si Gyeonggi-do 16677 (KR); LEE, Kwangjae, Suwon-si Gyeonggi-do 16677 (KR)
(74) Representative: Appleyard Lees IP LLP
(86) International application number: PCT/KR2022/017229
(87) International publication number: WO 2023/128226

(57) **Abstract**

A display apparatus disclosed herein comprises a plurality of display modules, a frame supporting the plurality of display modules such that the plurality of display modules is horizontally arranged in a matrix of M*N, the frame comprising a board receiving portion formed on an opposite surface to a surface facing the plurality of display modules, a board bracket accommodated in the board receiving portion and mounted on the frame, and a circuit board accommodated in the board receiving portion, mounted on the board bracket, and electrically connected to the plurality of display modules.

## Description

### [Technical Field]

The disclosure relates to a display apparatus for displaying an image by combining modules mounted on a substrate with inorganic light-emitting elements that are self-emissive light.

### [Background Art]

A display device visually displays data information, such as text, shapes, or the like, as well as images, or the like.

Typically, a liquid crystal panel that requires a backlight or an organic light-emitting diode (OLED) panel, which is made of a film of organic compounds that emit light by themselves in response to an electric current, are mainly used as display devices. However, the liquid crystal panel suffer from slow response times, high power consumption, and difficulty in compacting because the liquid crystal panel is not self-emissive and requires backlighting. While the OLED panel is self-emissive, the OLED panel does not require backlighting and may be made thinner, but the OLED panel is susceptible to burn-in, a phenomenon that occurs when the same screen is displayed for a long period of time, where certain areas of the previous screen remain when the screen is replaced as sub-pixels age.

Accordingly, a micro light-emitting diode ("micro LED" or "µLED") display panel is being researched as a new panel to replace a liquid crystal display panel or an OLED display panel, with inorganic light-emitting elements mounted on a substrate and the inorganic light-emitting elements themselves used as pixels.

The micro LED display panel is a type of flat display panel including a plurality of inorganic LEDs, each of which is 100 micrometers or less in size.

Such a LED display panel is also a self-emissive device. However, since micro LEDs are inorganic LEDs, the micro LED display panel is not subject to the burn-in phenomenon of OLEDs, and has excellent brightness, resolution, power consumption, and durability.

A micro LED display panel provides better contrast, response time, and energy efficiency compared to a liquid crystal display (LCD) panel that requires backlighting. Both organic LEDs and micro LEDs, which are inorganic light-emitting elements, have good energy efficiency, but the micro LEDs are superior to the OLEDs in terms of brightness, luminous efficiency, and lifetime.

In addition, the pixel-by-pixel arrangement of LEDs on a circuit board enables modularization of displays on a board-by-board basis, making it easy to produce a variety of resolutions and screen sizes to meet consumer demand.

### [Disclosure]

### [Technical Problem]

Provided is a display apparatus with reduced thickness.

Provided is a display apparatus with improved strength of a frame supporting a plurality of display modules.

### [Technical Solution]

According to an aspect of the disclosure, a display apparatus includes a plurality of display modules, a frame supporting the plurality of display modules such that the plurality of display modules is horizontally arranged in a matrix of M*N, the frame including a board receiving portion formed on an opposite surface to a surface facing the plurality of display modules, a board bracket accommodated in the board receiving portion and mounted on the frame, and a circuit board accommodated in the board receiving portion, mounted on the board bracket, and electrically connected to the plurality of display modules.

The frame may include a frame panel having a first side facing the plurality of display modules and a second side opposite the first side, and the board receiving portion may be formed through the frame panel from the first side to the second side of the frame panel.

The frame may include a reinforcing member attached to the first side of the frame panel and provided to cover the board receiving portion at the first side.

The plurality of display modules may be attached to the reinforcing member.

The board bracket may include a panel mounting portion provided to be elastically deformable when the board bracket is mounted on the frame panel.

The panel mounting portion may protrude toward an outside of the board bracket.

The board bracket may include a board mounting portion provided to be elastically deformable when the circuit board is mounted on the board bracket.

The board mounting portion may protrude toward an inside of the board bracket.

The board bracket may include a material having a higher strength than the circuit board.

The board receiving portion may be provided in a size corresponding to the circuit board.

The frame panel may have a thickness greater than the circuit board.

The frame may include a plurality of module openings formed to correspond to the plurality of display modules, and the board receiving portion may be disposed between the plurality of module openings.

The display apparatus may further include a timing controller board that generates timing signals for controlling the plurality of display modules, wherein the circuit board is electrically connected to the timing controller board.

According to another aspect of the disclosure, a display apparatus includes a plurality of display modules, and a frame supporting the plurality of display modules such that the plurality of display modules are horizontally arranged in a matrix of M*N, the frame comprising a frame panel formed with a board receiving portion extending from a first side facing the plurality of display modules to a second side opposite the first side, and a reinforcing member attached to the first side of the frame panel to cover the board receiving portion at the first side of the frame panel, and a circuit board accommodated in the board receiving portion and electrically connected to the plurality of display modules.

The display apparatus may further include a board bracket accommodated in the board receiving portion and mounted on the frame panel, the board bracket being provided to enable mounting of the circuit board.

The board bracket may include a panel mounting portion provided to be elastically deformable when the board bracket is mounted on the frame panel.

The board bracket may include a board mounting portion provided to be elastically deformable when the circuit board is mounted on the board bracket.

The board bracket may include a material having a higher strength than the circuit board.

The board receiving portion may be provided in a size corresponding to the circuit board.

The display apparatus may further include a timing controller board that generates timing signals for controlling the plurality of display modules, wherein the circuit board is electrically connected to the timing controller board.

### [Advantages Effects]

According to one or more embodiments of the disclosure, the display apparatus may reduce the thickness of the display apparatus because the board receiving portion in which the circuit board is accommodated is formed in the frame supporting the plurality of display modules.

According to one or more embodiments of the disclosure, the display apparatus may improve the strength of the frame since the board bracket is mounted on the board receiving portion of the frame, and the circuit board is mounted on the board bracket.

### [Description of Drawings]

FIG. 1 shows a display apparatus according to an embodiment of the disclosure.
FIG. 2 shows an exploded view of a major configuration of the display apparatus shown in FIG. 1.
FIG. 3 is an enlarged cross-sectional view of a partial configuration of a first display module of the display apparatus shown in FIG. 1.
FIG. 4 shows a rear view of the first display module of the display apparatus shown in FIG. 1.
FIG. 5 shows a rear view of a frame shown in FIG. 2.
FIG. 6 shows an exploded view of the frame shown in FIG. 5.
FIG. 7 is an enlarged view of section A shown in FIG. 5.
FIG. 8 shows a circuit board shown in FIG. 7 disassembled from a board bracket.
FIG. 9 shows a cross-section along the line B-B' shown in FIG. 7.
FIG. 10 shows a cross-section along the line C-C' shown in FIG. 8.
FIG. 11 is a block diagram of electrical connections of the circuit board shown in FIG. 5.
FIG. 12 is an enlarged view of a portion of a display apparatus according to another embodiment of the disclosure.

### [Modes of the Invention]

Embodiments described in the disclosure and configurations shown in the drawings are merely examples of the embodiments of the disclosure and may be modified in various different ways at the time of filing of the present application to replace the embodiments and drawings of the disclosure.

In addition, the same reference numerals or signs shown in the drawings of the disclosure indicate elements or components performing substantially the same function. The singular form of a noun corresponding to an item may include one or a plurality of the items unless clearly indicated otherwise in a related context. Drawings may be exaggerated for the purpose of clarifying the shape and size of elements.

In this disclosure, the terms "including", "having", and the like are used to specify features, numbers, steps, operations, elements, components, or combinations thereof, but do not preclude the presence or addition of one or more of the features, numbers, steps, operations, elements, components, or combinations thereof.

In addition, the meaning of "identical" in this disclosure includes having similar properties or being similar within a certain range. Identical also includes "substantially identical". It should be understood that the meaning of "substantially identical" includes values that fall within the margin of error in manufacturing or values that fall within a range of variation that is not meaningful with respect to a reference value.

Embodiments of the disclosure will be described in detail below with reference to the accompanying drawings.

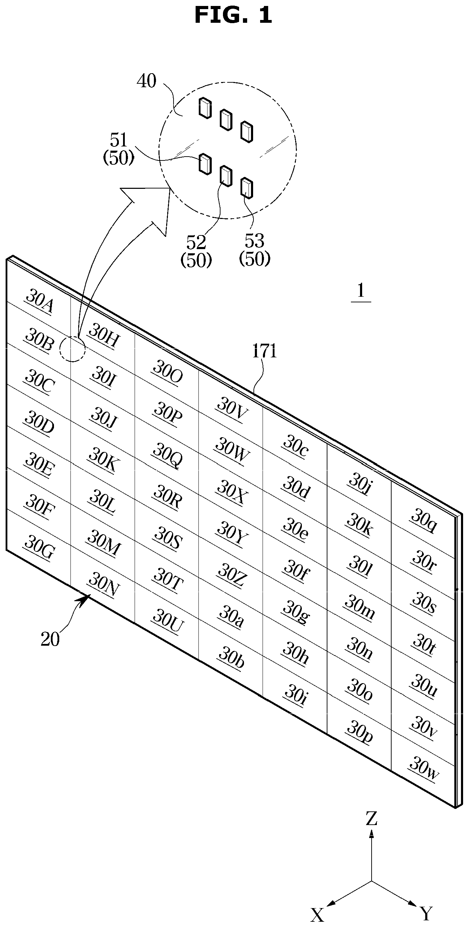

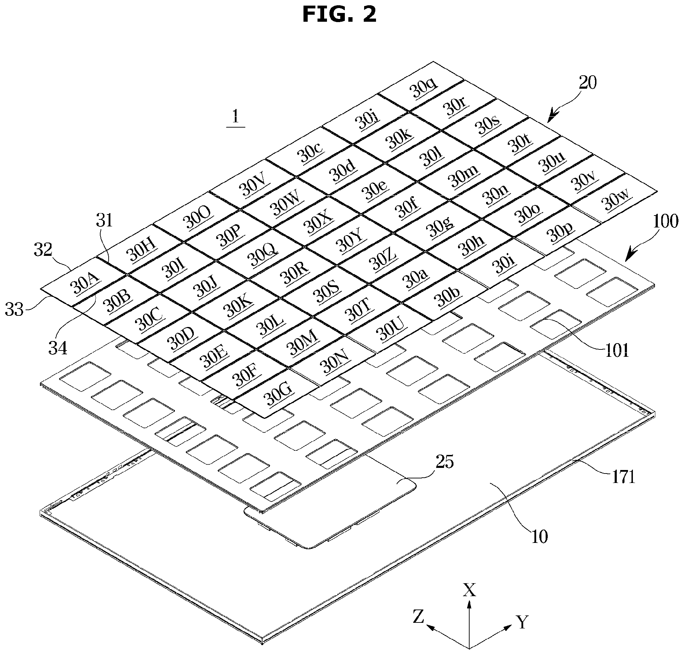

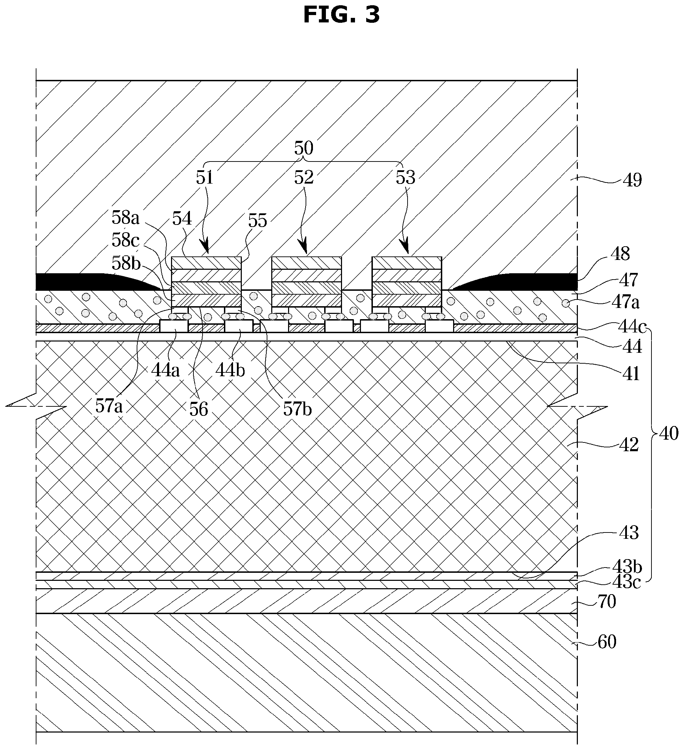

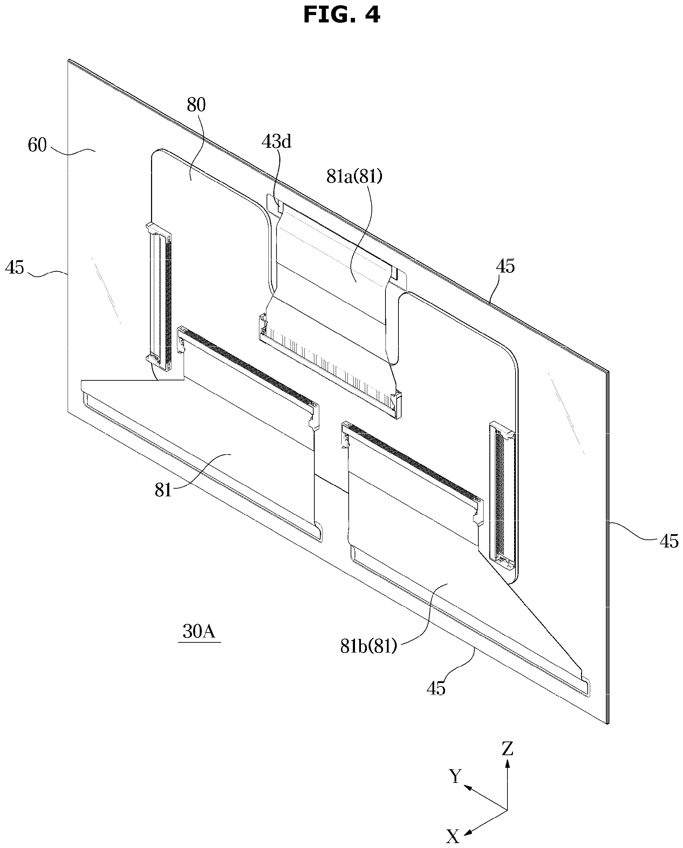

FIG. 1 shows a display apparatus according to an embodiment of the disclosure. FIG. 2 shows an exploded view of main components of the display apparatus shown in FIG. 1. FIG. 3 shows an enlarged cross-section of a portion of a display module of the display apparatus shown in FIG. 1. FIG. 4 shows a rear surface of one display module of the display apparatus shown in FIG. 1.

Some components of the display apparatus 1, including a plurality of inorganic light-emitting elements 50 shown in the drawings, may be micro-scale configurations having a size of several µm to several hundred of µm, and for ease of description, the scale of some components (e.g., the plurality of inorganic light-emitting elements 50, a black matrix 48, and the like) is exaggerated.

A display apparatus 1 may be a device that displays information, materials, data, and the like in the form of texts, shapes, graphs, images, and the like, and a television (TV), a personal computer (PC), a mobile, a digital signage, and the like may be implemented as the display apparatus 1.

According to an embodiment of the disclosure, as shown in FIGS. 1 and 2, the display apparatus 1 may include a display panel 20 that displays an image (including a video), and a power supply device (not shown) that supplies power to the display panel 20, a main board 25 that controls the overall operation of the display panel 20, a frame 100 that supports the display panel 20, a rear cover 10 that covers a rear side of the frame 100, and a front chassis 171 that covers an edge of the frame 100.

The display panel 20 may include a plurality of display modules 30A-30w, a drive board (not shown) that drives each of the display modules 30A-30w, and a timing controller board (TCON) 90 that generates timing signals required to control each of the display modules 30A-30w.

The rear cover 10 may support the display panel 20. The rear cover 10 may be installed on a floor by means of a stand (not shown), or may be mounted on a wall by means of a hanger (not shown), or the like.

The front chassis 171 may be coupled to the frame 100 by means of a separate bracket (not shown).

The plurality of display modules 30A-30w may be arranged up, down left and right so as to be adjacent to each other. The plurality of display modules 30A-30w may be arranged in an M*N matrix. In the present embodiment, 49 display modules 30A-30w are provided and arranged in a 7 * 7 matrix, but there is no limit to the number and arrangement of the display modules 30A-30w.

The plurality of display modules 30A-30w may be mounted on the frame 100. The plurality of display modules 30A-30w may be mounted on the frame 100 by a variety of conventional methods, such as a magnetic force by a magnet, a mechanical fitting structure, or adhesive. The rear cover 10 may be coupled to the rear side of the frame 100, and the rear cover 10 may form a rear exterior of the display apparatus 1.

The rear cover 10 may include a metallic material. Accordingly, heat generated from the plurality of display modules 30A-30w and the frame 100 may be easily conducted to the rear cover 10, thereby increasing the heat dissipation efficiency of the display apparatus 1.

As such, the display apparatus 1 according to an embodiment of the disclosure may implement a large screen by tiling a plurality of display modules 30A-30w.

In a contrast to an embodiment of the disclosure, each of the plurality of display modules 30A-30w, i.e., the respective display module, may be applicable to the display apparatus. In other words, the display modules 30A-30w as a single unit, may be mounted and applied to wearable devices, portable devices, handheld devices, and electronic products or electronic components requiring various displays, and may be applied to display apparatus, such as PC monitors, high-resolution TVs and signage, electronic displays, and the like through a plurality of assembly arrangements in a metric type as in the embodiment of the disclosure.

The plurality of display modules 30A-30w may have the same configuration as each other. Accordingly, the description of any one display module described below may be equally applicable to all other display modules.

As an example of the first display module 30A of the plurality of display modules 30A-30w, the first display module 30A may be formed in a quadrangle type. The first display module 30A may be provided in a rectangular shape or a square shape.

As a result, the first display module 30A may include edges 31, 32, 33, and 34 formed in the up, down, left, and right directions based on a first direction X, which is the front.

As shown in FIG. 3, the plurality of display modules 30A-30w may each include a substrate 40, and the plurality of inorganic light-emitting elements 50 mounted on the substrate 40. The plurality of inorganic light-emitting elements 50 may be mounted on a mounting surface 41 of the substrate 40 facing in the first direction X. In FIG. 3, the thickness of the substrate 40 in the first direction X is shown to be exaggeratedly thick for ease of description.

The substrate 40 may be formed in a quadrangle type. As described above, the plurality of display modules 30A-30w may each be provided in a quadrangle shape, and accordingly the substrate 40 may also be formed in a quadrangle shape.

The substrate 40 may be arranged in a rectangular type or a square type.

Accordingly, exemplifying the first display module 30A, the substrate 40 may include four edges corresponding to the edges 31, 32, 33, and 34 of the first display module 30A formed in the up, down, left, and right directions based on the first direction X, which is the front.

The substrate 40 may include a base substrate 42, a mounting surface 41 forming one side of the base substrate 42, a rear surface 43 forming the other side of the base substrate 42 and disposed opposite the mounting surface 41, and a side surface 45 disposed between the mounting surface 41 and the rear surface 43.

The substrate 40 may include a thin film transistor (TFT) layer 44 formed on the base substrate 42 to drive the inorganic light-emitting elements 50. The base substrate 42 may include a glass substrate. That is, the substrate 40 may include a chip on glass (COG) type substrate. The substrate 40 may be provided with first and second pad electrodes 44a and 44b provided so that the inorganic light-emitting elements 50 may be electrically connected to the TFT layer 44.

The TFT included in the TFT layer 44 may not be limited to a particular structure or type, and may be configured in various embodiments. In other words, the TFT of the TFT layer 44 according to an embodiment of the disclosure may be implemented not only as a low temperature polysilicon (LTPS) TFT, an oxide TFT, and a polysilicon or a-silicon (Si) TFT, but also as an organic TFT and a graphene TFT.

In addition, the TFT layer 44 may be replaced by a complementary metal-oxide semiconductor (CMOS) type, n-type metal oxide semiconductor field effect transistor (MOSFET), or p-type MOSFET transistor when the base substrate 42 of the substrate 40 is made from a silicon wafer.

The plurality of inorganic light-emitting elements 50 may be formed of an inorganic material and may include inorganic light-emitting elements each having a width, length, and height in the range of several µm to tens of µm. The respective micro inorganic light-emitting element may have a size of 100 µm or less in the length of a short side of the width, length, and height. In other words, the inorganic light-emitting elements 50 may be picked up from a wafer made of a sapphire or a silicon and directly transferred onto the substrate 40. The plurality of inorganic light-emitting elements 50 may be picked up and transferred through an electrostatic method using an electrostatic head or a stamp method using an elastic polymeric material, such as polydimethylsiloxane (PDMS) or silicone as a head.

The plurality of inorganic light-emitting elements 50 may be a light emitting structure including an n-type semiconductor 58a, an active layer 58c, a p-type semiconductor 58b, a first contact electrode 57a, and a second contact electrode 57b.

Although not shown in the drawings, one of the first contact electrode 57a and the second contact electrode 57b may be electrically connected to the n-type semiconductor 58a, and the other may be electrically connected to the p-type semiconductor 58b.

The first contact electrode 57a and the second contact electrode 57b may be in the form of a flip chip, wherein the first contact electrode 57a and the second contact electrode 57b are disposed horizontally and face in the same direction (opposite to a direction of light emission).

The inorganic light-emitting element 50 may each include a light emitting surface 54 disposed in the first direction X when mounted on the mounting surface 41, side surfaces 55, and a bottom surface 56 disposed on the opposite side of the light emitting surface 54, and the first contact electrode 57a and the second contact electrode 57b may be formed on the bottom surface 56.

In other words, the contact electrodes 57a and 57b of the inorganic light-emitting element 50 may be disposed on the opposite side of the light emitting surface 54 and thus be disposed on the opposite side of a direction in which light is emitted.

The contact electrodes 57a and 57b may be disposed to face the mounting surface 41 and be provided to be electrically connected to the TFT layer 44, and the light emitting surface 54 which emits light may be disposed in a direction opposite to the direction in which the contact electrodes 57a and 57b are disposed.

Accordingly, when the light generated in the active layer 58c is irradiated in the first direction X through the light emitting surface 54, the light may be irradiated in the first direction X without interference from the first contact electrode 57a or the second contact electrode 57b.

In other words, the first direction X may be defined as the direction in which the light emitting surface 54 is arranged to emit light.

The first contact electrode 57a and the second contact electrode 57b may be electrically connected to the first pad electrode 44a and the second pad electrode 44b formed on the mounting surface 41 side of the substrate 40, respectively.

The inorganic light-emitting element 50 may be directly connected to the pad electrodes 44a and 44b through an anisotropic conductive layer 47 or a bonding configuration, such as solder.

The anisotropic conductive layer 47 may be formed on the substrate 40 to mediate electrical bonding between the contact electrodes 57a and 57b and the pad electrodes 44a and 44b. The anisotropic conductive layer 47 may be formed by an anisotropic conductive adhesive attached on a protective film, and may have a structure in which conductive balls 47a are dispersed in an adhesive resin. The conductive balls 47a may be conductive spheres surrounded by a thin insulating film, which may electrically connect the conductors to each other by breaking the insulating film under pressure.

The anisotropic conductive layer 47 may include an anisotropic conductive film (ACF) in the form of a film, and an anisotropic conductive paste (ACP) in the form of a paste.

Accordingly, when the plurality of inorganic light-emitting elements 50 are mounted on the substrate 40, pressure may be applied to the anisotropic conductive layer 47 to allow the insulating film of the conductive balls 47a to be broken. As a result, the contact electrodes 57a and 57b of the inorganic light-emitting element 50 and the pad electrodes 44a and 44b of the substrate 40 may be electrically connected.

However, although not shown in the drawings, the plurality of inorganic light-emitting elements 50 may also be mounted to the substrate 40 through solder (not shown) instead of the anisotropic conductive layer 47. After the inorganic light-emitting elements 50 are aligned on the substrate 40, the inorganic light-emitting elements 50 may be bonded to the substrate 40 by a reflow process.

The plurality of inorganic light-emitting elements 50 may include a red light-emitting element 51, a green light-emitting element 52, and a blue light-emitting element 53. The plurality of inorganic light-emitting elements 50 may be mounted on the mounting surface 41 of the substrate 40 as a unit with a series of the red light-emitting element 51, the green light-emitting element 52, and the blue light-emitting element 53. A series of the red light emitting element 51, the green light emitting element 52, and the blue light emitting element 53 may form a single pixel. In this case, the red light emitting element 51, the green light emitting element 52, and the blue light emitting element 53 may each form a sub-pixel.

The red light-emitting element 51, the green light-emitting element 52, and the blue light-emitting element 53 may be arranged in a row at predetermined intervals as in an embodiment of the disclosure, or may be arranged in other shapes, such as a triangular shape.

The substrate 40 may include a light absorbing layer 44c to enhance contrast by absorbing ambient light. The light absorbing layer 44c may be formed on the entire mounting surface 41 side of the substrate 40. The light absorbing layer 44c may be formed between the TFT layer 44 and the anisotropic conductive layer 47.

The plurality of display modules 30A-30w may further include the black matrix 48 formed between the plurality of inorganic light-emitting elements 50.

The black matrix 48 may perform a function of complementing the light absorbing layer 44c formed entirely on the mounting surface 41 side of the substrate 40. In other words, the black matrix 48 may absorb ambient light, causing the substrate 40 to appear black, thereby improving the contrast of the screen.

The black matrix 48 may preferably have a black color.

In the present embodiment, the black matrix 48 may be formed to be disposed between pixels formed by a series of the red light-emitting element 51, the green light-emitting element 52, and the blue light-emitting element 53. However, unlike the present embodiment, the black matrix 48 may be formed more finely to divide each of the light emitting elements 51, 52, and 53 which are sub-pixels.

The black matrix 48 may be formed in a grid shape with horizontal and vertical patterns so as to be disposed between pixels.

The black matrix 48 may be formed by applying a light-absorbing ink onto the anisotropic conductive layer 47 by an ink-jet process, followed by curing, or by coating a light-absorbing film on the anisotropic conductive layer 47.

In other words, in the anisotropic conductive layer 47 formed entirely on the mounting surface 41, the black matrix 48 may be formed on a space between the plurality of inorganic light-emitting elements 50 on which the plurality of inorganic light-emitting elements 50 are not mounted.

Each of the plurality of display modules 30A-30w may include a front cover 49 disposed on the mounting surface 41 in the first direction X to cover the mounting surface 41 of the plurality of display modules 30A-30w.

The front cover 49 may be provided in a plurality to be formed on the plurality of display modules 30A-30w in the first direction X, respectively.

The front cover 49 may include a film (not shown). The front cover 49 may include an adhesive layer (not shown) arranged to bond the front cover 49 to the mounting surface 41 of the substrate 40.

The film (not shown) of the front cover 49 may be provided as a functional film having optical performance.

The front cover 49 may be arranged to cover the substrate 40 to protect the substrate 40 from an external force.

Typically, the adhesive layer (not shown) of the front cover 49 may be arranged to have a height greater than a predetermined height in the first direction X in which the mounting surface 41 or the light emitting surface 54 faces. This is to sufficiently fill a gap that may be formed between the front cover 49 and the plurality of inorganic light-emitting elements 50 when the front cover 49 is disposed on the substrate 40.

Each of the plurality of display modules 30A-30w may include a heat dissipation member (or a heat sink) 60 on the rear surface 43 of the substrate 40 to dissipate heat generated by the substrate 40.

The heat generated from the substrate 40 may include heat generated in different configurations. The heat that accounts for the largest portion of the heat generated in the substrate 40 to be transferred to the rear surface 43 may be the heat generated when the plurality of inorganic light-emitting elements 50 are emitted. However, in addition to the above, heat may be generated in a plurality of configurations disposed on the mounting surface 41 of the substrate 40, such as the TFT layer 44, and the heat generated in the plurality of configurations may be introduced into the substrate 40.

In addition, heat may be transferred to the substrate 40 from the outside of the substrate 40, and heat may be transferred to the substrate 40 through configurations other than the substrate 40, thereby generating heat in the substrate 40.

The heat generated in the substrate 40 described below may refer to heat generated by a plurality of configurations disposed on the substrate 40 including the substantially plurality of inorganic light-emitting elements 50 that is introduced into the substrate 40.

In particular, as described above, the heat generated in the plurality of inorganic light-emitting elements 50 may enter the substrate 40 in the largest amount, and thus the largest portion of the heat generated in the substrate 40 may be the heat generated by the plurality of inorganic light-emitting elements 50. However, as described above, it should be understood that heat may be generated in the substrate 40 by heat generated in different configurations and outside the substrate 40, in addition to the plurality of inorganic light-emitting elements 50. In addition, each of the plurality of display modules 30A-30w may include an adhesive tape 70 disposed between the rear surface 43 of the substrate 40 and the heat dissipation member 60 to bond the rear surface 43 of the substrate 40 and the heat dissipation member 60.

The plurality of inorganic light-emitting elements 50 may be electrically connected to an upper surface wiring layer (not shown) formed by a pixel-driven wiring (not shown), which is formed on the mounting surface 41, and a pixel-driven wiring (not shown), which extends through the side surface 45 of the substrate 40.

The upper surface wiring layer (not shown) may be formed on a lower side of the anisotropic conductive layer 47. The upper surface wiring layer (not shown) may be electrically connected to a side surface wiring (not shown), which is formed on the side surface 45 of the substrate 40. The side surface wiring (not shown) may be arranged in the form of a thin film form.

The upper surface wiring layer (not shown) may be connected to the side surface wiring (not shown) by an upper surface connection pad (not shown) formed on a border side of the substrate 40.

The side surface wiring (not shown) may be connected to a rear surface wiring layer 43b, which extends along the side surface 45 of the substrate 40 and formed on the rear surface 43.

An insulating layer 43c covering the rear surface wiring layer 43b may be formed on the rear surface wiring layer 43b in a direction in which the rear surface of the substrate 40 faces.

In other words, the plurality of inorganic light-emitting elements 50 may be electrically connected to the upper surface wiring layer (not shown), the side surface wiring (not shown), and the rear surface wiring layer 43b in sequence.

Furthermore, as shown in FIG. 4, the display module 30A may include a drive circuit board 80 arranged to electrically control the plurality of inorganic light-emitting elements 50 mounted on the mounting surface 41. The drive circuit board 80 may be formed as a printed circuit board (PCB). The drive circuit board 80 may be disposed on the rear surface 43 of the substrate 40 in the first direction X. In particular, the drive circuit board 80 may be located on the heat dissipation member 60 bonded to the rear surface 43 of the substrate 40.

The display module 30A may include a flexible film 81 connecting the drive circuit board 80 and the rear surface wiring layer 43b so that the drive circuit board 80 is electrically connected to the plurality of inorganic light-emitting elements 50.

One end of the flexible film 81 may be connected to a rear surface connection pad 43d disposed on the rear surface 43 of the substrate 40 and electrically connected to the plurality of inorganic light-emitting elements 50.

The rear surface connection pad 43d may be electrically connected to the rear surface wiring layer 43b. Accordingly, the rear surface connection pad 43a may electrically connect the rear surface wiring layer 43b and the flexible film 81.

The flexible film 81 may transmit power and electrical signals from the drive circuit board 80 to the plurality of inorganic light-emitting elements 50 because the flexible film 81 is electrically connected to the rear surface connection pad 43d.

The flexible film 81 may be formed of a flexible flat cable (FFC) or a chip on film (COF), or the like.

The flexible film 81 may include a first flexible film 81a and a second flexible film 81b, which are respectively disposed in a vertical direction with respect to the front first direction X, which is the front.

The first and second flexible films 81a and 81b are not limited thereto, and may be arranged in a left-to-right direction with respect to the first direction X, or in at least two directions in the up, down, left, and right directions, respectively.

The second flexible films 81b may be provided in a plurality. However, the present disclosure is not limited thereto, and the second flexible film 81b may be provided in a single. The first flexible film 81a may also be provided in a plurality.

The first flexible film 81a may transmit a data signal from the drive circuit board 80 to the substrate 40. The first flexible film 81a may be provided as a COF.

The second flexible film 81b may transmit power from the drive circuit board 80 to the substrate 40. The second flexible film 81b may be provided as an FFC.

However, the present disclosure is not limited thereto, and the first and second flexible films 81a and 81b may be formed opposite to each other.

Although not shown in the drawings, the drive circuit board 80 may be electrically connected to the main board 25 (see FIG. 2). The main board 25 may be disposed on the rear side of the frame 100, and the main board 25 may be connected to the drive circuit board 80 through a cable (not shown) at the rear side of the frame 100.

As described above, the heat dissipation member 60 may be arranged to abut the substrate 40. The heat dissipation member 60 and the substrate 40 may be bonded by the adhesive tape 70 disposed between the rear surface 43 of the substrate 40 and the heat dissipation member 60.

The heat dissipation member 60 may be formed of a material having a high thermal conductivity or may be implemented in a configuration having a high thermal conductivity. For example, the heat dissipation member 60 may be made of aluminum.

The heat generated by the plurality of inorganic light-emitting elements 50 and the TFT layer 44 mounted on the substrate 40 may be transferred to the heat dissipation member 60 via the adhesive tape 70 along the rear surface 43 of the substrate 40.

Accordingly, the heat generated in the substrate 40 may be easily transferred to the heat dissipation member 60, so that the substrate 40 may be prevented from rising above a certain temperature.

Each of the plurality of display modules 30A-30w may be arranged in a matrix of M*N at different locations. Each of the plurality of display modules 30A-30w may be individually movable. In this case, each of the plurality of display modules 30A-30w may individually include the heat dissipation member 60 to maintain a certain level of heat dissipation performance regardless of which position each display module 30A-30w is located.

The plurality of display modules 30A-30w may form a screen of different sizes of the display apparatus 1 in the form of a matrix of different M*N. Accordingly, instead of heat dissipation using a single heat dissipation member for heat dissipation, heat dissipation by each of the plurality of display modules 30A-30w including an independent heat dissipation member 60, as in an embodiment of the disclosure, may improve the heat dissipation performance of the display apparatus 1 as a whole.

When a single heat dissipation member is disposed within the display apparatus 1, based on a front-to-back direction, a portion of the heat dissipation member may not be disposed at a position corresponding to a position where some display modules are disposed and a portion of the heat dissipation member may be disposed at a position where no display module is disposed, thereby reducing the heat dissipation efficiency of the display apparatus 1.

In other words, by means of the heat dissipation members 60 disposed on each of the display modules 30A-30w, all of the display modules 30A-30w may be self-dissipated by the respective heat dissipation members 60 regardless of where the display modules 30A-30w are disposed, thereby improving the heat dissipation performance of the display apparatus 1 as a whole.

The individual heat dissipation member 60 may be provided in a quadrangle shape that roughly corresponds to the shape of the substrate 40.

The area of the substrate 40 may be at least equal to or larger than the area of the heat dissipation member 60. When the substrate 40 and the heat dissipation member 60 are arranged side by side in the first direction X, the four edges of the substrate 40 in the quadrangle shape with respect to the center of the substrate 40 and the heat dissipation member 60 may be formed correspondingly to the four edges of the heat dissipation member 60, or may be arranged to be further outwardly disposed with respect to the center of the substrate 40 and the heat dissipation member 60 than the four edges of the heat dissipation member 60.

Preferably, the four edges of the substrate 40 may be arranged further outside than the four edges of the heat dissipation member 60. That is, the area of the substrate 40 may be arranged to be larger than the area of the heat dissipation member 60.

More specifically, when heat is transferred to each of the display modules 30A-30w, the substrate 40 and the heat dissipation member 60 may be thermally expanded. Since the heat dissipation member 60 has a higher thermal expansion rate than the substrate 40, the value at which the heat dissipation member 60 is expanded is higher than the value at which the substrate 40 is expanded.

In this case, when the four edges of the substrate 40 are arranged corresponding to or further inwardly than the four edges of the heat dissipation member 60, the edges of the heat dissipation member 60 may protrude to the outside of the substrate 40.

Accordingly, a spacing length of the gap formed between each of the display modules 30A-30w may be formed irregularly due to thermal expansion of the heat dissipation member 60 of each of the display modules 30A-30w, which may increase the perception of some seams, thereby reducing the uniformity of the screen of the display panel 20.

However, when the four edges of the substrate 40 are arranged further outwardly than the four edges of the heat dissipation member 60, although the substrate 40 and the heat dissipation member 60 are thermally expanded, the heat dissipation member 60 may not protrude outwardly from the four edges of the substrate 40. Accordingly, the spacing length of the gap formed between each of the display modules 30A-30w may be kept constant.

According to an embodiment of the disclosure, the area of the substrate 40 and the area of the heat dissipation member 60 may be arranged to approximately correspond. As a result, heat generated in the substrate 40 may be uniformly dissipated over the entire area of the substrate 40, rather than being isolated in some areas.

The heat dissipation member 60 may be arranged to be bonded to the rear surface 43 of the substrate 40 by the adhesive tape 70.

The adhesive tape 70 may be provided in a size corresponding to the heat dissipation member 60. In other words, the area of the adhesive tape 70 may be arranged to correspond to the area of the heat dissipation member 60. The heat dissipation member 60 may be provided in a substantially quadrangle shape, and the adhesive tape 70 may be provided in a quadrangle shape corresponding thereto.

Based on the center of the heat dissipation member 60 and the adhesive tape 70, the edges of the heat dissipation member 60 and the edges of the adhesive tape 70 having a quadrangle shape may be formed to correspond to each other.

Accordingly, the heat dissipation member 60 and the adhesive tape 70 may be easily manufactured in one combined configuration, thereby increasing the manufacturing efficiency of the entire display apparatus 1.

That is, when the heat dissipation member 60 is cut in a unit number on one plate, the adhesive tape 70 is pre-bonded to one plate before the heat dissipation member 60 is cut, and then the adhesive tape 70 and the heat dissipation member 60 are cut in a unit simultaneously, thereby reducing the process.

The heat generated from the substrate 40 may be transferred to the heat dissipation member 60 through the adhesive tape 70. Accordingly, the adhesive tape 70 may be arranged to bond the heat dissipation member 60 to the substrate 40 and at the same time to transfer the heat generated from the substrate 40 to the heat dissipation member 60.

Accordingly, the adhesive tape 70 may include a material having a high heat dissipation performance.

The adhesive tape 70 may include a material having adhesive properties to bond the substrate 40 and the heat dissipation member 60.

The adhesive tape 70 may include a material having a higher heat dissipation performance than a material having typical adhesive properties. Accordingly, the adhesive tape 70 may efficiently transfer heat between the substrate 40 and the heat dissipation member 60 to the respective configurations.

Furthermore, the adhesive material of the adhesive tape 70 may be formed of a material having a higher heat dissipation performance than the adhesive material comprising a conventional adhesive.

A material with high heat dissipation performance may refer to a material that may effectively transfer heat with high thermal conductivity, high thermal transmittance, and low specific heat.

For example, the adhesive tape 70 may include a graphite material. However, the adhesive tape 70 is not limited thereto and may generally be made of a material with high heat dissipation performance.

The ductility of the adhesive tape 70 may be arranged to be greater than that of the substrate 40 and the heat dissipation member 60. Accordingly, the adhesive tape 70 may be made of a material having adhesion and heat dissipation properties and high ductility. The adhesive tape 70 may be formed as an inorganic double-sided tape. The adhesive tape 70 formed as an inorganic double-sided tape may be formed as a single layer between one side adhered to the substrate 40 and the other side adhered to the heat dissipation member 60 without a base supporting one side and the other side.

Since the adhesive tape 70 does not include the base, the adhesive tape 70 does not include a material that impedes heat conduction, and thus heat dissipation performance may be increased. However, the adhesive tape 70 may be not limited to an inorganic double-sided tape, and may be arranged as a heat dissipating tape having better heat dissipation performance than a conventional double-sided tape.

Since the substrate 40 may be made of a glass material and the heat dissipation member 60 may be made of metal, the material properties of each configuration may be different, and thus the extent to which the material is deformed by the same heat may be different. In other words, when heat is generated in the substrate 40, the substrate 40 and the heat dissipation member 60 may each be expanded to different sizes due to the heat. This may cause the display module 30A to be damaged.

This is because, when the substrate 40 and the heat dissipation member 60 are fixed to each other, the substrate 40 and the heat dissipation member 60 may be expanded to different sizes due to different expansion values of the substrate 40 and the heat dissipation member 60 at the same temperature, which may cause stresses in their respective configurations.

Among the material properties, particularly where the coefficient of thermal expansion of each material is different, the extent to which the material is physically deformed by heat varies. In particular, the coefficient of thermal expansion of a metallic material is generally greater than that of a glass material, so that when the same heat is transferred to the substrate 40 and the heat dissipation member 60, the heat dissipation member 60 may expand and deform more than the substrate 40.

Conversely, when the heat generation in the substrate 40 ends and the substrate 40 and the heat dissipation member 60 cool down, the heat dissipation member 60 may shrink and deform more than the substrate 40.

Since the substrate 40 and the heat dissipation member 60 are bonded together by the adhesive tape 70, external force may be transmitted to the substrate 40 when the heat dissipation member 60 deforms more than the substrate 40.

Conversely, external force may be transmitted from the heat dissipation member 60 by the substrate 40, but since the strength of the substrate 40 made of glass is less than the strength of the metal heat dissipation member 60, the substrate 40 may be damaged.

The adhesive tape 70 may be provided between the substrate 40 and the heat dissipation member 60 to absorb external forces transmitted by different configurations of the substrate 40 and the heat dissipation member 60 as the substrate 40 and the heat dissipation member 60 expand to different sizes.

This may prevent external forces from being transferred to the substrate 40 and the heat dissipation member 60, and in particular, prevent the substrate 40 from being damaged.

To absorb the external forces transmitted by the substrate 40 and the heat dissipation member 60, the adhesive tape 70 may be provided with a highly ductile material. In detail, the ductility of the adhesive tape 70 may be arranged to be greater than the ductility of the substrate 40 and the heat dissipation member 60.

Accordingly, when an external force generated by a change in size of the substrate 40 and the heat dissipation member 60 is transmitted to the adhesive tape 70, the adhesive tape 70 itself may be deformed, thereby preventing the external force from being transmitted to different configurations.

The adhesive tape 70 may have a predetermined thickness in the first direction X. When the heat dissipation member 60 is thermally expanded or cooled to contract by heat generation, the heat dissipation member 60 may expand not only in the first direction X but also in a direction perpendicular to the first direction X, thereby transmitting an external force to the substrate 40.

As described above, the display panel 20 may display a screen using the plurality of display modules 30A-30w. In this case, the uniformity (or integrity) of the screen may be degraded by a seam formed by the gap between the plurality of display modules 30A-30w.

Accordingly, to minimize the perception of seams in the display panel 20, the plurality of display modules 30A-30w may be arranged on the frame 100 to form a constant gap. This is because when the gaps formed by the plurality of display modules 30A-30w are not constant, the perception of the seam may be enhanced due to some gaps.

In conventional display apparatuses, the frame supporting the display panel is made of a metallic material. The plurality of display modules is tiled on the frame made of a metallic material.

When the display apparatus is operated, the substrate forming the plurality of display modules 30A-30w may be thermally expanded by heat generated from the display panel. As described above, the plurality of display modules 30A-30w may be supported on the frame made of a metallic material, and due to the thermal expansion of the substrate and the thermal expansion of the frame, the gap between the plurality of display modules 30A-30w may be irregularly formed, resulting in the promoting the perception of the seam.

In other words, the substrates of the plurality of display modules 30A-30w are all made of a glass material, and each substrate may be thermally expanded to a certain value, but the width of some of the gaps in the gaps between the plurality of display modules 30A-30w may be formed irregularly due to the thermal expansion of the metal frame supporting each substrate. This is because the physical properties of the metallic material and the physical properties of the glass material are different.

The material properties of a material may vary depending on the coefficient of thermal expansion, specific heat, and thermal conductivity, and the like. In particular, the magnitude of thermal expansion of the substrate and the frame may differ due to the difference between the coefficient of thermal expansion of the metallic material and the coefficient of thermal expansion of the glass material.

In addition to the thermal expansion of the substrate of the plurality of display modules 30A-30w, the frame to which the plurality of display modules 30A-30w are bonded may also itself thermally expand, causing the spacing length of the gap between the plurality of display modules 30A-30w to change irregularly.

To prevent the spacing length between the plurality of display modules 30A-30w from becoming irregularly arranged due to thermal expansion after the plurality of display modules 30A-30w are arranged on the frame made of a metallic material, the frame 100 of the display apparatus 1 according to an embodiment of the disclosure may be made of a material to which the plurality of display modules 30A-30w are bonded and which is formed with material properties similar to the material properties of the substrate 40 of the plurality of display modules 30A-30w.

In other words, the frame 100 may be arranged to have material properties similar to those of the substrate 40 such that the spacing length of the gap formed between each of the display modules 30A-30w is maintained constant.

The definition of being formed with material properties similar to those of the substrate 40 described above may include that the coefficient of thermal expansion, specific heat, and thermal conductivity of the substrate 40 are similar. In particular, according to an embodiment of the disclosure, it may be understood to include that the coefficient of thermal expansion of the substrate 40 and the coefficient of thermal expansion of the frame 100 correspond to each other.

The frame 100 may be formed entirely of a material having the material properties similar to those of the substrate 40, or may be formed of a material having a value of a similar coefficient of thermal expansion. Preferably, the frame 10 may be formed of a material having the same value as the coefficient of thermal expansion of the substrate 40.

Without being limited thereto, the frame 100 may include a front layer (not shown) made of a material having material properties corresponding to those of the substrate 40.

The substrate 40 may be bonded to the front layer (not shown) in the first direction X. Accordingly, the substrate 40 and the front layer (not shown) may be arranged to expand to corresponding lengths when the same heat is transferred to the substrate 40 and the front layer (not shown) in a second direction Y or a third direction Z orthogonal to the first direction X.

In other words, when the frame 100 is formed entirely of a material having material properties corresponding to those of the substrate 40, or only the front layer (not shown) forming a front surface of the frame 100, is formed of a material having material properties corresponding to those of the substrate 40, according to some embodiments of the disclosure, the front surface of the frame 100 to which the substrate 40 of the display modules 30A-30w is bonded may thermally expand to the same value as the substrate 40 when the substrate of the plurality of display modules 30A-30w is thermally expanded by heat generated during operation of the display apparatus 1.

As the front surface of the frame 100, which is the base surface to which the plurality of display modules 30A-30w are bonded, is thermally expanded to the same level as the substrate 40 of the plurality of display modules 30A-30w, the spacing length of the gaps formed between the plurality of display modules 30A-30w may be maintained at the same level.

Accordingly, as the gaps formed between the plurality of display modules 30A-30w may be maintained at the same spacing length of the gaps as in a state in which the substrate 40 is not thermally expanded, a certain level of seam may be maintained, thereby maintaining the uniformity of the screen of the display panel 20.

As a result, although heat generated by operation of the display apparatus 1 is supplied to the substrate 40 of the plurality of display modules 30A-30w, the spacing length of the gaps between the plurality of display modules 30A-30w may be maintained constant, and accordingly some of the seams may be amplified to prevent a phenomenon in which the uniformity of the screen is reduced.

The frame 100 may be configured to support the display panel 20 and may be arranged to have a strength of a predetermined value or greater. Accordingly, the frame 100 may be formed of a metallic material having a predetermined strength or greater, and the front surface of the frame 100 may be formed of a glass material corresponding to the substrate 40. However, the frame 100 is not limited thereto and may be formed of a material having a coefficient of thermal expansion different from the coefficient of thermal expansion of the substrate 40.

Hereinafter, the frame 100 according to an embodiment of the disclosure will be described in detail.

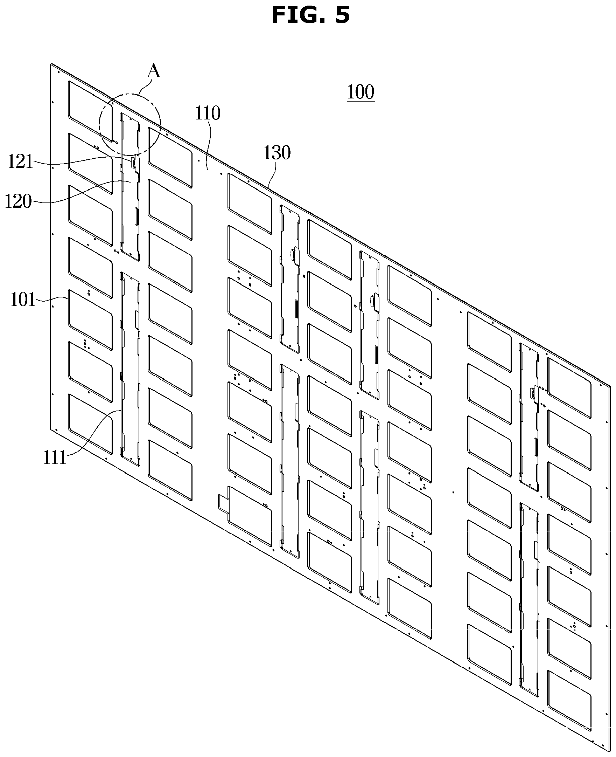

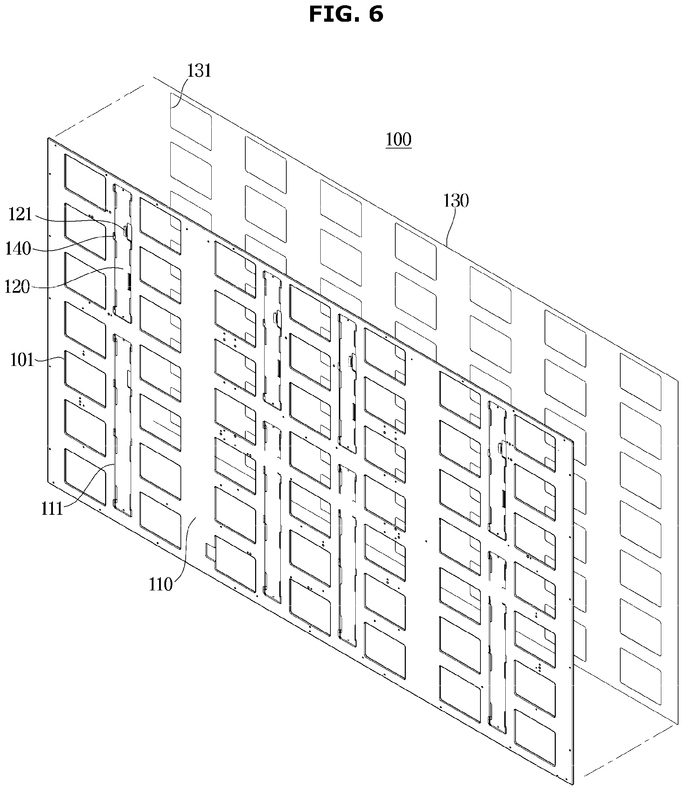

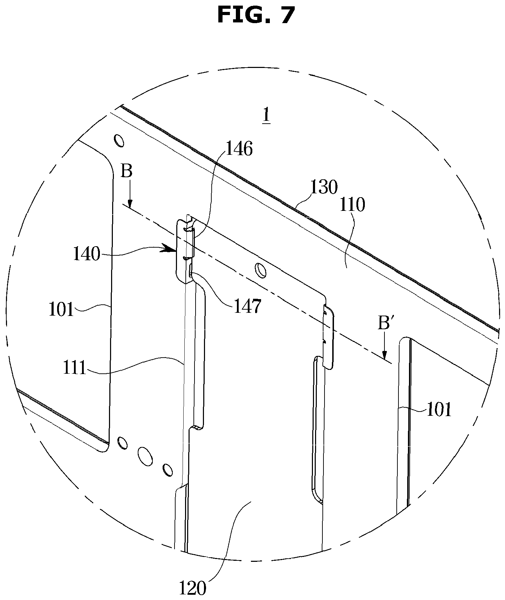

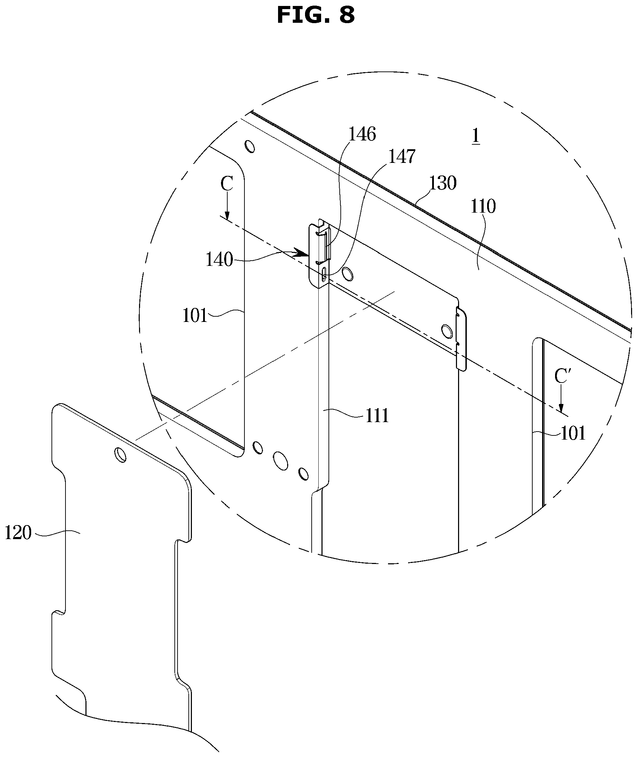

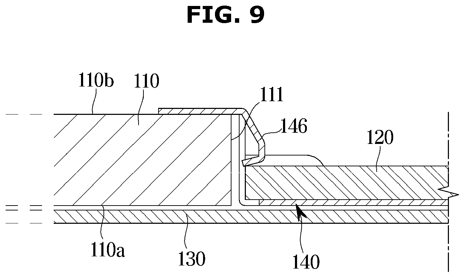

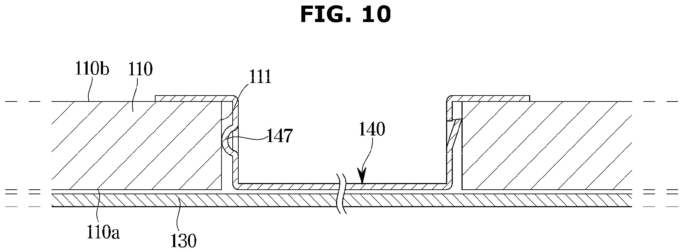

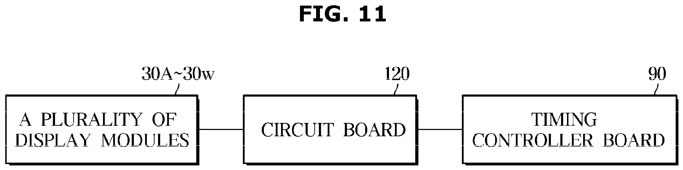

FIG. 5 shows the rear surface of the frame shown in FIG. 2. FIG. 6 shows an exploded view of the frame shown in FIG. 5. FIG. 7 shows an enlarged view of section A shown in FIG. 5. FIG. 8 shows the circuit board shown in FIG. 7 disassembled from the board bracket. FIG. 9 shows a cross-section along the line B-B' shown in FIG. 7. FIG. 10 shows a cross-section along the line C-C' shown in FIG. 8. FIG. 11 shows a block diagram of the electrically connective relationship of the circuit board shown in FIG. 5.

Referring to FIGS. 5 and 6, the frame 100 may include a frame panel 110. Referring to FIGS. 9 and 10, the frame panel 110 may include a first side 110a facing the plurality of display modules 30A-30w, and a second side 110b opposite the first side 110a. The first side 110a may be directed forward, and the second side 110b may be directed backward.

The frame panel 110 may include a plurality of module openings 101 formed to correspond to the plurality of display modules 30A-30w. The plurality of module openings 101 may allow the plurality of display modules 30A-30w to be electrically connected to a circuit board 120.

The frame panel 110 may include a board receiving portion 111 formed therethrough in the front-to-back direction. The board receiving portion 111 may extend from the first side 110a to the second side 110b of the frame panel 110. The board receiving portion 111 may be formed through the frame panel 110 from the first side 110a to the second side 110b of the frame panel 110. The board receiving portion 111 may have a size and/or shape corresponding to the circuit board 120. The board receiving portion 111 may be formed on one side of the frame 100 facing the plurality of display modules 30A-30w and on the opposite side.

The board receiving portion 111 may be disposed between the pluralities of module openings 101. More particularly, the board receiving portion 111 may have a substantially rectangular shape, and the plurality of module openings 101 may be disposed on opposite sides of the board receiving portion 111. Such a structure may cause the circuit board 120 disposed in the board receiving portion 111 to be electrically connected to the plurality of display modules 30A-30w.

The frame 100 may include a reinforcing member 130 attached to the first side 110a of the frame panel 110. The reinforcing member 130 may be arranged to cover the board receiving portion 111 from the first side 110a. The plurality of display modules 30A-30w may be mounted on the reinforcing member 130. The reinforcing member 130 may comprise carbon fiber reinforced plastics (CFRP).

The reinforcing member 130 may include a member opening 131 formed to correspond to the module opening 101. The member opening 131 may allow the plurality of display modules 30A-30w to be electrically connected to the circuit board 120.

The display apparatus 1 may include the circuit board 120 accommodated in the board receiving portion 111 of the frame 100. Referring to FIG. 11, the circuit board 120 may be electrically connected to the plurality of display modules 30A-30w. The circuit board 120 may be electrically connected to a timing controller board 90. The circuit board 120 may control the plurality of display modules 30A-30w based on timing signals generated by the timing controller board 90. The display apparatus 1 may include a connector 121 provided on the circuit board 120 so that the circuit board 120 may be electrically connected to the timing controller board 90.

The circuit board 120 may be mounted on a board bracket 140. The circuit board 120 may have a size and/or shape corresponding to the board receiving portion 111. The circuit board 120 may be embedded in the board receiving portion 111.

The thickness of the circuit board 120 may be arranged to be smaller than the depth of the board receiving portion 111. The thickness of the circuit board 120 may be arranged to be smaller than the thickness of the frame panel 110. The circuit board 120 may be arranged so as not to protrude from the frame panel 110 when accommodated in the board receiving portion 111. As a result, the display apparatus 1 may be prevented from increasing in thickness by the circuit board 120.

The display apparatus 1 may include the board bracket 140 mounted on the board receiving portion 111 of the frame panel 110. The board bracket 140 may be accommodated in the board receiving portion 111. The board bracket 140 may reinforce the strength of the frame panel 110, which may be reduced by forming the board receiving portion 111 on the frame panel 110. The board bracket 140 may be made of a material having a higher strength than the circuit board 120.

The board bracket 140 may be configured to include a material having an elasticity. The board bracket 140 may be configured to include a material having an elastic and restoring force.

Referring to FIGS. 7 through 9, the board bracket 140 may include a board mounting portion 146. The board mounting portion 146 may be arranged to couple the circuit board 120 to the board bracket 140 in a snap-fit manner. The board mounting portion 146 may be arranged to be elastically deformed while the circuit board 120 is mounted on the board bracket 140. The board mounting portion 146 may protrude toward the inside of the board bracket 140 on which the circuit board 120 is mounted.

Referring to FIGS. 7, 8, and 10, the board bracket 140 may include a panel mounting portion 147. The panel mounting portion 147 may be arranged to couple the board bracket 140 to the frame panel 110 in a press-fit manner. The panel mounting portion 147 may be arranged to be elastically deformable while the board bracket 140 is mounted to the frame panel 110. The panel mounting portion 147 may protrude in a direction opposite to a direction in which the board mounting portion 146 protrudes. The panel mounting portion 147 may protrude toward the outside of the board bracket 140.

A process of mounting the circuit board 120 of the display apparatus 1 to the frame 100 according to an embodiment of the disclosure will be described.

First, the circuit board 120 may be mounted on the board bracket 140. The circuit board 120 may be mounted on the board bracket 140 while pressing the board mounting portion 146 of the board bracket 140. The board mounting portion 146 is pressed and deformed by the circuit board 120 and then restored, thereby being positioned to secure the circuit board 120.

The board bracket 140 on which the circuit board 120 is mounted may be mounted on the frame 100. The board bracket 140 may be mounted to the board receiving portion 111 formed on the frame panel 110 of the frame 100. The board bracket 140 may be mounted on the frame panel 110 with the panel mounting portion 147 deformed as the panel mounting portion 147 is pressed against an inner circumferential surface of the board receiving portion 111. The board bracket 140 may be secured to the frame panel 110 by the elastic restoring force of the panel mounting portion 147.

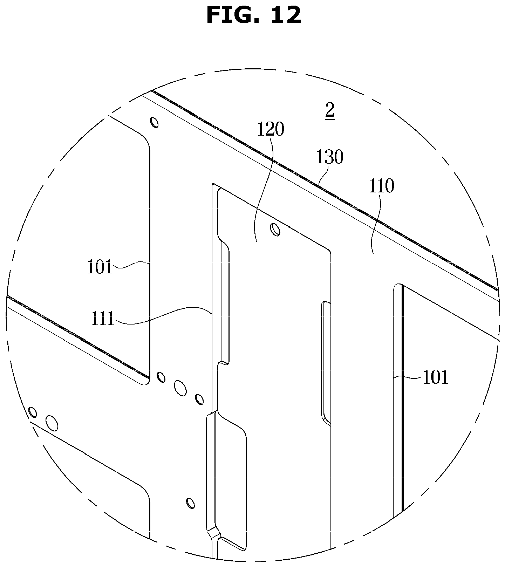

FIG. 12 shows an enlarged view of a portion of a display apparatus according to another embodiment of the disclosure.

Referring to FIG. 12, a display apparatus 2 according to another embodiment of the disclosure will be described. In describing the display apparatus 2 shown in FIG. 12, the same components as the display apparatus 1 shown in FIG. 7 are assigned the same reference numerals and detailed description thereof may be omitted.

Referring to FIG. 12, in contrast to the display apparatus 1 shown in FIG. 7, the display apparatus 2 may eliminate the board bracket 140. The circuit board 120 may be accommodated in the board receiving portion 111 of the frame panel 110. The circuit board 120 may be attached to the reinforcing member 130. Accordingly, the display apparatus 2 may have a further reduction in thickness than the display apparatus 1 including the board bracket 140.

Although certain example embodiments are illustrated and described above, the present disclosure is not limited to the certain embodiments, various applications may of course be performed by those skilled in the art without deviating from what is claimed in the scope of claims, and such applications should not be understood separately from the technical idea or prospects herein.

## Claims

1. A display apparatus comprising:
a plurality of display modules;
a frame supporting the plurality of display modules such that the plurality of display modules is horizontally arranged in a matrix of M*N, the frame comprising a board receiving portion formed on an opposite surface to a surface facing the plurality of display modules;
a board bracket accommodated in the board receiving portion and mounted on the frame; and
a circuit board accommodated in the board receiving portion, mounted on the board bracket, and electrically connected to the plurality of display modules.

2. The display apparatus of claim 1, wherein
the frame comprises a frame panel having a first side facing the plurality of display modules and a second side opposite the first side, and
wherein the board receiving portion is formed through the frame panel from the first side to the second side of the frame panel.

3. The display apparatus of claim 2, wherein the frame comprises a reinforcing member attached to the first side of the frame panel and provided to cover the board receiving portion at the first side.

4. The display apparatus of claim 3, wherein the plurality of display modules is attached to the reinforcing member.

5. The display apparatus of claim 1, wherein the board bracket comprises a panel mounting portion provided to be elastically deformable when the board bracket is mounted on the frame panel.

6. The display apparatus of claim 5, wherein the panel mounting portion protrudes toward an outside of the board bracket.

7. The display apparatus of claim 1, wherein the board bracket comprises a board mounting portion provided to be elastically deformable when the circuit board is mounted on the board bracket.

8. The display apparatus of claim 7, wherein the board mounting portion protrudes toward an inside of the board bracket.

9. The display apparatus of claim 1, wherein the board bracket includes a material having a higher strength than the circuit board.

10. The display apparatus of claim 1, wherein the board receiving portion is provided in a size corresponding to the circuit board.

11. The display apparatus of claim 1, wherein the frame panel is thicker than the circuit board.

12. The display apparatus of claim 1, wherein
the frame comprises a plurality of module openings formed to correspond to the plurality of display modules, and
wherein the board receiving portion is disposed between the plurality of module openings.

13. The display apparatus of claim 1, further comprising a timing controller board that generates timing signals for controlling the plurality of display modules,
wherein the circuit board is electrically connected to the timing controller board.
